# EUROPEAN PATENT SPECIFICATION

(11) **EP 2 757 483 B1**
(45) Date of publication and mention of the grant of the patent: **16.03.2016**
(21) Application number: 14151614.6
(22) Date of filing: 17.01.2014
(51) Int. Cl.: G06F 13/38

(54) **APPARATUS AND METHOD FOR EXTENDING MEMORY IN TERMINAL**
VORRICHTUNG UND VERFAHREN ZUR ERWEITERUNG EINES SPEICHERS IN EINEM ENDGERÄT
APPAREIL ET PROCÉDÉ D'EXTENSION DE MÉMOIRE DANS UN TERMINAL

(30) Priority: 18.01.2013 KR 20130005981
(43) Date of publication of application: 23.07.2014
(73) Proprietor: Samsung Electronics Co., Ltd, Gyeonggi-do 443-742 (KR)
(72) Inventor: Yun, Sung-Hwan, 443-742 Gyeonggi-do (KR); Kim, Sei-Jin, 443-742 Gyeonggi-do (KR)
(74) Representative: Birchenough, Lewis

(56) References cited:
- EP-A1- 1 768 021
- US-A1- 2003 208 650
- US-A1- 2007 094 439

## Description

The present disclosure relates to an apparatus and a method for extending a memory in a terminal. More particularly, the present disclosure relates to an apparatus and a method capable of selectively extending a memory in a terminal.

### Description of the Related Art

The amount of a volatile memory, for example, a Dynamic Random Access Memory (DRAM), included in a terminal is limited. Accordingly, when available space is insufficient in a DRAM having a limited storage capacity, an operation speed of a system may become lower, an application which is being executed may be terminated, or a new Operating System (OS) may not be updated.

Typically, data or codes are stored in a DRAM. Accordingly, when available space of the DRAM is insufficient in the case of making a request for recording new data or a new code, data or a code having the lowest frequency of use is detected. When the code is detected that has already been stored in a non-volatile memory of the terminal, the available space of the DRAM is secured by deleting the detected code.

However, when data is detected, the data is recorded as data having the highest priority of the frequency of use, and then data or a code having a low frequency of use is detected.

US 2003/208650 is disclosing a computer system implementing hot mirroring for main system memory. That is, the computer system permits a user to hot plug a new memory board into the system and the system will respond by switching to a mirrored memory mode in which write cycles are performed to both memory boards (new and old). Once a new board is hot plugged into the system, the contents of the old board are copied over, in a background mode, to the new board so that both boards will have the same data.

When codes are all deleted and only data is stored in the DRAM through the above-described operation, if a request is made for recording new data or a new code, the DRAM cannot store the new data or code any longer. Accordingly, a problem occurs in that an application which is being executed is terminated. Moreover, an external memory device having a built-in non-volatile memory, for example, Not-AND (NAND) memory, may be inserted into the terminal. When data stored in the DRAM is moved to the NAND memory of the external memory device, the speed of moving the data becomes lower, and the lifespan of the terminal becomes shorter.

Therefore, there is a need for an apparatus and a method capable of selectively extending a memory in a terminal.

The above information is presented as background information only to assist with an understanding of the present disclosure. No determination has been made, and no assertion is made, as to whether any of the above might be applicable as prior art with regard to the present disclosure.

### SUMMARY OF THE INVENTION

Aspects of the present disclosure are to address at least the above-mentioned problems and/or disadvantages and to provide at least the advantages described below. Accordingly, an aspect of the present disclosure is to provide an apparatus and a method capable of selectively extending a memory in a terminal.

Another aspect of the present disclosure is to provide an apparatus and a method by which, in a terminal, a Linux swap technology can be used to extend an external memory having a built-in Random Access Memory (RAM) to a system memory and thereby use can be made of the external memory having the built-in RAM which is extended to the system memory.

In accordance with an aspect of the present disclosure, an apparatus that extends a memory in a terminal is provided. The apparatus includes a socket unit into which an external memory having a built-in RAM is inserted, and a controller that performs a control operation for moving data stored in a RAM of the terminal to the RAM of the external memory and for securing available space of the RAM of the terminal, when the external memory having the built-in RAM is inserted into the socket unit.

In accordance with another aspect of the present disclosure, a method of extending a memory in a terminal is provided. The method includes determining a type of an external memory inserted into a socket unit of the terminal, and securing available space of a RAM of the terminal by moving data stored in the RAM of the terminal to a RAM of the external memory, when the external memory inserted into the socket unit of the terminal corresponds to an external memory having a built-in RAM.

Other aspects, advantages, and salient features of the disclosure will become apparent to those skilled in the art from the following detailed description, which, taken in conjunction with the annexed drawings, discloses various embodiments of the present disclosure.

### BRIEF DESCRIPTION OF THE DRAWINGS

The above and other aspects, features, and advantages of certain embodiments of the present disclosure will be more apparent from the following description taken in conjunction with the accompanying drawings, in which:
FIG. 1 is a block diagram illustrating a configuration of a terminal according to an embodiment of the present disclosure;
FIGS. 2A and 2B are views each illustrating an external memory having a built-in Random Access Memory (RAM) according to an embodiment of the present disclosure;
FIG. 3 is a flowchart illustrating a method by which a memory is extended and used in a terminal, according to an embodiment of the present disclosure;
FIG. 4A and FIG. 4B are flowcharts illustrating a process for swapping out data stored in a RAM of a terminal from the RAM of the terminal to a RAM of an external memory connected to the terminal, according to an embodiment of the present disclosure;
FIG. 5 is a view illustrating a list enumerating data stored in a RAM of a terminal according to a frequency of use of the data, according to an embodiment of the present disclosure; and
FIG. 6 is a flowchart illustrating a process for swapping in data stored in a RAM of an external memory connected to a terminal from the RAM of the external memory to a RAM in the terminal, according to an embodiment of the present disclosure. Throughout the drawings, it should be noted that like reference numbers are used to depict the same or similar elements, features, and structures.

### DETAILED DESCRIPTION OF THE EXEMPLARY EMBODIMENTS

The following description with reference to the accompanying drawings is provided to assist in a comprehensive understanding of various embodiments of the present disclosure as defined by the claims and their equivalents. It includes various specific details to assist in that understanding but these are to be regarded as merely exemplary. Accordingly, those of ordinary skill in the art will recognize that various changes and modifications of the various embodiments described herein can be made without departing from the scope of the present disclosure. In addition, descriptions of well-known functions and constructions may be omitted for clarity and conciseness.

The terms and words used in the following description and claims are not limited to the bibliographical meanings, but, are merely used by the inventor to enable a clear and consistent understanding of the present disclosure. Accordingly, it should be apparent to those skilled in the art that the following description of various embodiments of the present disclosure is provided for illustration purposes only and not for the purpose of limiting the as defined by the appended claims and their equivalents.

It is to be understood that the singular forms "a," "an," and "the" include plural referents unless the context clearly dictates otherwise. Thus, for example, reference to "a component surface" includes reference to one or more of such surfaces.

Although the terms including ordinal numbers such as first and second may be used herein to describe various elements, these elements should not be limited by these terms. These terms are only used to distinguish one element from another. For example, a first element could be termed a second element, and similarly, a second element could be termed a first element, without departing from the scope of right of the present disclosure. The terminology used herein is for the purpose of describing particular embodiments of the present disclosure, and does not limit the scope of the present disclosure. As used herein, the term "and/or" includes any and all combinations of one or more of the associated listed items.

Examples of a terminal according to an embodiment of the present disclosure include a portable terminal and a fixed terminal. In this embodiment of the present disclosure, the portable terminal is an electronic device which is easy to carry and can be easily moved. Examples of the portable terminal may include a video phone, a mobile phone, a smart phone, a Wideband Code Division Multiple Access (WCDMA) terminal, a Universal Mobile Telecommunication Service (UMTS) terminal, a Personal Digital Assistant (PDA), a Portable Multimedia Player (PMP), a Digital Multimedia Broadcasting (DMB) terminal, an Electronic book (E-book), a laptop computer, a Tablet Personal Computer (TPC), a digital camera, a Global Positioning System (GPS) navigation, a portable game console, and the like. Examples of the fixed terminal may include a desktop computer, a Personal Computer (PC), an optical disc player, a set-top box, a High Definition Television (HDTV), a home appliance, and the like.

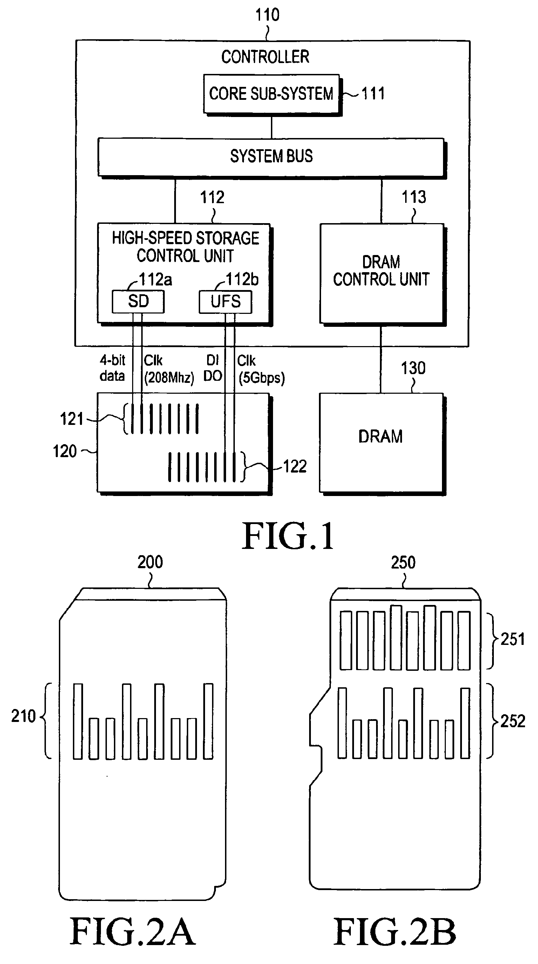

FIG. 1 is a block diagram illustrating a configuration of a terminal according to an embodiment of the present disclosure. FIGS. 2A and 2B are views each illustrating an external memory having a built-in Random Access Memory (RAM) according to an embodiment of the present disclosure.

Referring to FIG. 1, the terminal in which a memory is extended and the extended memory is used, includes a controller 110, a socket unit 120, and a Dynamic Random Access Memory (DRAM) 130.

The controller 110 controls an overall operation of the terminal. According to various embodiments of the present disclosure, the controller 110 serves as not only a Central Processing Unit (CPU), but also a Graphic Processing Unit (GPU), and according to design, performs the same functions as those of an Application Processor (AP) capable of serving as a communication chip and performing even additional functions (e.g., an audio function, a Universal Serial Bus (USB) function, and the like).

According to various embodiments of the present disclosure, when an external memory having a built-in RAM is inserted into the socket unit 120, the controller 110 performs a control operation for moving data (e.g., transferring data or otherwise communicating data) stored in the DRAM 130 of the terminal to a RAM of the external memory, thereby securing available space of the DRAM 130 of the terminal.

According to various embodiments of the present disclosure, when the external memory having the built-in RAM is inserted into the socket unit 120, the controller 110 includes a Universal Flash Storage (UFS) interface 112b capable of moving data at a high speed between the RAM of the external memory and the DRAM 130 of the terminal.

According to various embodiments of the present disclosure, the controller 110 performs a control operation for swapping in/out data in a unit of page between the DRAM 130 of the terminal and the RAM of the external memory by using a swap technology.

According to various embodiments of the present disclosure, when a system booting operation is performed in the terminal, the controller 110 receives particular information from the external memory having the built-in RAM, which is inserted into (e.g., or otherwise operatively connected to) the socket unit 120, and determines the type of the external memory based on the received particular information. When the controller 110 determines that the external memory has a built-in RAM, the controller 110 performs a control operation for registering the RAM of the external memory as a block device and for then swapping in/out data between the DRAM 130 of the terminal and the RAM of the external memory by using the swap technology.

According to various embodiments of the present disclosure, when available space is insufficient in the DRAM 130 of the terminal in the case of making a request for recording new data or a new code, the controller 110 performs a control operation for swapping out data having the lowest frequency of use among data stored in the DRAM 130 of the terminal from the DRAM 130 of the terminal to the RAM of the external memory and thereby recording the new data or code within available space of the DRAM 130 of the terminal. After the controller 110 performs a control operation for swapping out the data stored in the DRAM 130 of the terminal from the DRAM 130 of the terminal to the RAM of the external memory, the controller 110 performs a control operation for changing a storage position information of the data swapped out to the RAM of the external memory and recording the changed storage position information thereof in a page management table. Thereafter, the controller 110 performs a control operation for recording data, which is newly stored in the DRAM 130 of the terminal, as data having the highest frequency of use.

According to various embodiments of the present disclosure, when a request is made for reading data stored in the RAM of the external memory, the controller 110 performs a control operation for swapping in data stored in the RAM of the external memory from the RAM of the external memory to the DRAM 130 of the terminal and then reading the data. After the controller 110 performs a control operation for swapping in the data stored in the RAM of the external memory from the RAM of the external memory to the DRAM 130 of the terminal, the controller 110 performs a control operation for changing a storage position information of the data swapped in to the DRAM 130 of the terminal and recording the changed storage position information thereof in a page management table. Thereafter, the controller 110 performs a control operation for recording the data, which has been swapped in from the RAM of the external memory to the DRAM 130 of the terminal, as data having the highest frequency of use.

According to various embodiments of the present disclosure, the controller 110 as described above includes a core sub-system 111, a high-speed storage control unit 112, and a DRAM control unit 113.

When an external memory having a built-in non-volatile memory, for example, Not-AND (NAND) memory, is inserted into the socket unit 120, the high-speed storage control unit 112 includes a Secure Digital (SD) interface 112a for transmitting/receiving particular information and data to/from the external memory having the built-in NAND memory which is inserted into the socket unit 120. When an external memory having a built-in RAM as volatile memory is inserted into the socket unit 120, the high-speed storage control unit 112 includes a UFS interface 112b as a high-speed interface for transmitting/receiving particular information and data to/from the external memory having the built-in RAM which is inserted into the socket unit 120.

When a system booting operation is performed in the terminal, if the high-speed storage control unit 112 receives, from the core sub-system 111, an inquiry command for detecting whether an external memory is inserted into the socket unit 120, the high-speed storage control unit 112 transmits the inquiry command to the external memory having the built-in RAM, which is inserted into the socket unit 120, through the UFS interface 112b.

When the high-speed storage control unit 112 receives a response signal to the inquiry command from the external memory through the UFS interface 112b, the high-speed storage control unit 112 transmits the response signal to the core sub-system 111.

When the high-speed storage control unit 112 receives particular information indicating the type of the external memory from the external memory through the UFS interface 112b, the high-speed storage control unit 112 transmits the particular information on the external memory to the core sub-system 111. The types of external memory include an external memory having a built-in RAM, an external memory having a built-in NAND memory, and an external memory having a built-in RAM and a built-in NAND memory.

Thereafter, under the control of the core sub-system 111, the high-speed storage control unit 112 transmits data, which is received from the DRAM control unit 113, to the RAM of the external memory through the UFS interface 112b.

Also, under the control of the core sub-system 111, the high-speed storage control unit 112 transmits data, which is received from the RAM of the external memory, to the DRAM control unit 113 through the UFS interface 112b.

Under the control of the core sub-system 111, the DRAM control unit 113 transmits data stored in the DRAM 130, to the high-speed storage control unit 112, and stores data received from the high-speed storage control unit 112, in the DRAM 130.

When a system booting operation is performed in the terminal, the core sub-system 111 transmits an inquiry command for detecting whether an external memory is inserted into the socket unit 120, to the socket unit 120 through the UFS interface 112b of the high-speed storage control unit 112.

When the core sub-system 111 receives a response signal to the inquiry command through the UFS interface 112b of the high-speed storage control unit 112, the core sub-system 111 determines that the external memory is inserted into (e.g., or otherwise operatively connected to) the socket unit 120. In contrast, when the core sub-system 111 does not receive the response signal to the inquiry command through the UFS interface 112b of the high-speed storage control unit 112, or when the core sub-system 111 receives incorrect data, the core sub-system 111 determines that the external memory is not inserted into (e.g., or otherwise operatively connected to) the socket unit 120, or that an error occurs.

When the core sub-system 111 receives particular information indicating the type of the external memory from the external memory through the UFS interface 112b of the high-speed storage control unit 112, the core sub-system 111 determines the type of the external memory inserted into the socket unit 120 based on the particular information. The particular information received from the external memory includes peripheral device type information indicating a unit of management (a block device or character device) of Linux, Removable Media Bit (RMB) information indicating whether a device is attachable/removable, and product identification/vendor specific information indicating the type (e.g., an external memory having a built-in RAM, an external memory having a built-in NAND memory, and an external memory having a built-in RAM and a built-in NAND memory) of an external memory.

When available space is insufficient in the DRAM 130 in the case of making a request for storing new data or a new code in the DRAM 130, the core sub-system 111 performs a control operation for swapping out data, which has the lowest frequency of use among data stored in the DRAM 130, from the DRAM 130 to the RAM of the external memory in a unit of page through the UFS interface 112b of the high-speed storage control unit 112. Thereafter, the core sub-system 111 performs a control operation for storing the new data or code in the available space of the DRAM 130, which is secured by swapping out the data. In the present example, the core sub-system 111 performs a control operation for changing a storage position information of the data swapped out to the RAM of the external memory and recording the changed storage position information thereof in a page management table which manages multiple pieces of information and storage positions information of data or codes which are stored in the DRAM 130. Thereafter, the core sub-system 111 performs a control operation for recording the data, which has been newly stored in the DRAM 130 of the terminal, as data having the highest frequency of use.

When a request is made for reading data stored in the RAM of the external memory, the core sub-system 111 performs a control operation for swapping in data stored in the RAM of the external memory from the RAM of the external memory to the DRAM 130 of the terminal in a unit of page through the UFS interface 112b of the high-speed storage control unit 112 and then reading the data.

In the present example, the core sub-system 111 performs a control operation for changing a storage position information of the data swapped in to the DRAM 130 and recording the changed storage position information thereof in the page management table. Thereafter, the core sub-system 111 performs a control operation for recording the data, which has been swapped in from the RAM of the external memory to the DRAM 130 of the terminal, as data having the highest frequency of use.

The socket unit 120 includes first terminals 121 for connecting to an external memory including a NAND memory, at a predetermined position. The first terminals 121 are connected to the SD interface 112a of the high-speed storage control unit 112.

The socket unit 120 may also include second terminals 122 for connecting to an external memory including a RAM, at a position different from the position of the first terminals 121. The second terminals 122 are connected to the UFS interface 112b of the high-speed storage control unit 112.

FIGS. 2A and 2B illustrate external memories each having a built-in RAM, which may be inserted into the socket unit 120 of the terminal according to an embodiment of the present disclosure.

Referring to FIG. 2A, an external memory having a built-in RAM is illustrated. According to various embodiments of the present disclosure, when the external memory 200 having the built-in RAM is inserted into the socket unit 120 of the terminal, the external memory 200 includes predetermined terminals 210 at a position capable of contacting the second terminals 122 of the socket unit 120. Referring to FIG. 2B, an external memory having a built-in RAM and a built-in NAND memory is illustrated. According to various embodiments of the present disclosure, when the external memory 250 having the built-in RAM and the built-in NAND memory is inserted into the socket unit 120 of the terminal, the external memory 250 includes predetermined terminals 252 at a position capable of contacting (e.g., configured to contact) the second terminals 122 of the socket unit 120, in order to use the RAM. In order to use the NAND memory simultaneously with the RAM, the external memory 250 includes predetermined terminals 251 at a position capable of contacting (e.g., configured to contact) the first terminals 121 of the socket unit 120.

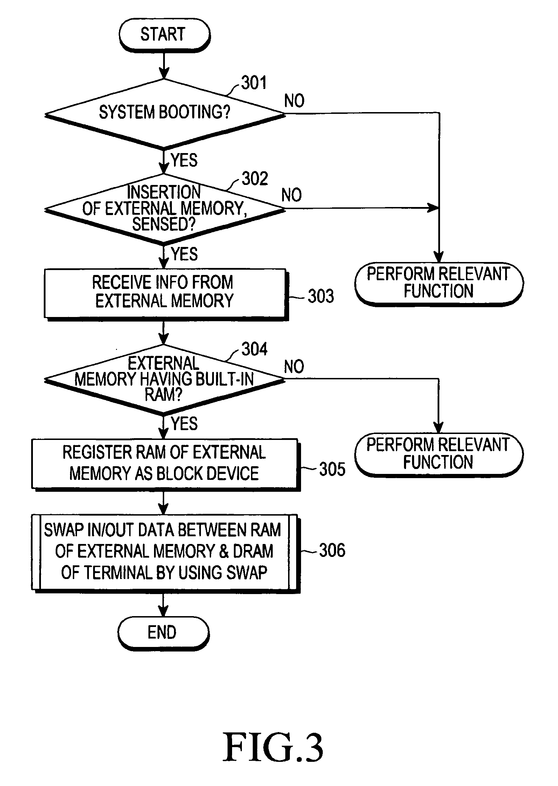

An operation of the terminal configured as described above for extending a memory and using the extended memory will be described in detail below with reference to FIG. 3 to FIG. 6. In the following various embodiments of the present disclosure, an example is described in which an external memory having a built-in RAM is inserted into the socket unit of the terminal. However, even when an external memory having a built-in RAM and a built-in NAND memory is inserted into the socket unit of the terminal, an operation similar to that of the example may be performed.

FIG. 3 is a flowchart illustrating a method by which a memory is extended and used in a terminal, according to an embodiment of the present disclosure. Hereinafter, various embodiments of the present disclosure will be described with reference to FIG. 1.

Referring to FIG. 3, at operation 301, the controller 110 determines whether a system booting operation is performed in the terminal. For example, when a system booting operation is performed in the terminal, the controller 110 detects that the system booting operation is performed in the terminal.

If the controller 110 determines that the system booting operation is not performed in the terminal at operation 301, then the controller 110 proceeds to perform a relevant function of the terminal.

In contrast, if the controller 110 determines that the system booting operation is performed in the terminal at operation 301, then the controller 110 proceeds to operation 302 at which the controller 110 determines whether the external memory is inserted into the terminal (e.g., or otherwise operatively connected to the terminal). For example, the controller 110 transmits an inquiry command to the socket unit 120 through the UFS interface 112b. When the controller 110 receives a response signal to the inquiry command from the socket unit 120 through the UFS interface 112b, the controller 110 detects that the external memory is inserted into the socket unit 120.

If the controller determines that the external memory is not inserted into the terminal at operation 302, then the controller 110 proceeds to perform a relevant function of the terminal.

In contrast, if the controller 110 determines that the external memory is inserted into the terminal at operation 302, then the controller 110 proceeds to operation 303 at which the controller 110 receives information from the external memory. When the controller 110 receives particular information indicating the type of the external memory from the external memory through the UFS interface 112b, the controller 110 determines the type of the external memory inserted into the socket unit 120 based on the particular information received from the external memory. At operation 304, the controller 110 determines whether the external memory has a built-in RAM.

If the controller 110 determines that the external memory does not have a built-in RAM at operation 304, then the controller 110 proceeds to perform a relevant function of the terminal.

In contrast, if the controller 110 determines that the external memory has a built-in RAM at operation 304, then the controller 110 proceeds to operation 305 at which the controller 110 registers the RAM of the external device as a block device. For example, when the controller 110 determines that the type of the external memory inserted into the socket unit 120 is the external memory 200 having the built-in RAM, the controller 110 detects that the type of the external memory inserted into the socket unit 120 is the external memory 200 having the built-in RAM, and proceeds to operation 305 at which the controller 110 registers the RAM of the external memory 200 as a block device.

Typically, units of management of Linux are classified into a block device accessed in a unit of sector and a character device accessed in a unit of byte. Because a memory is managed as the block device, the memory is registered as the block device. According to various embodiments of the present disclosure, the memory may only be swapped when the memory is registered as the block device.

At operation 306, the controller 110 swaps in/out data between the RAM of the external memory and the DRAM 130 of the terminal by using the swap capable of moving data between two RAMs, and thereby extends the RAM of the external memory to a system memory and causes the RAM of the external memory, which is extended to the system memory, to be used as the system memory.

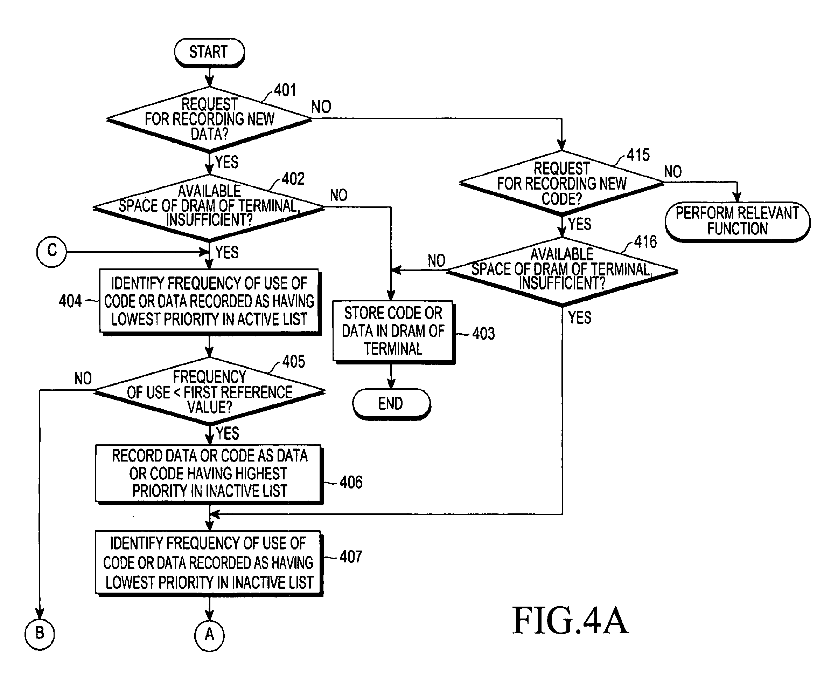

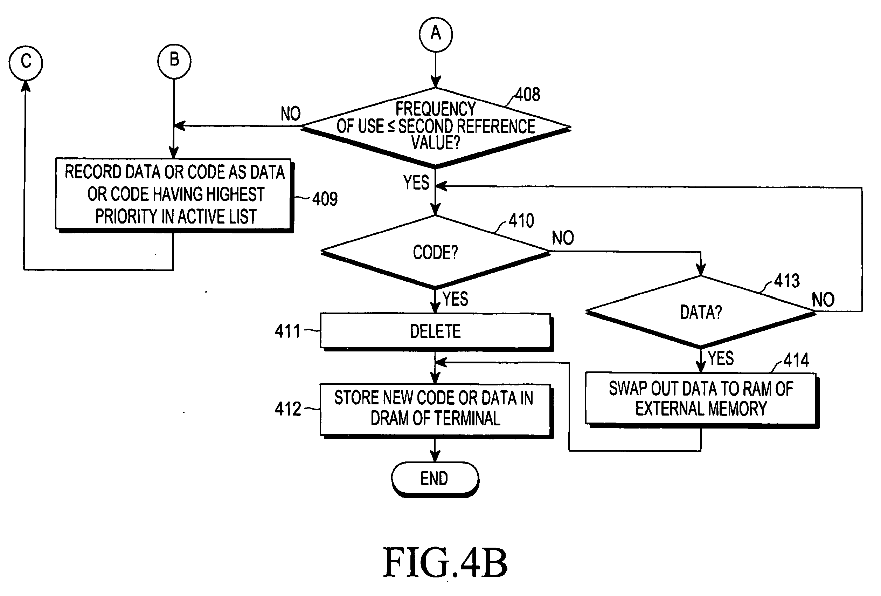

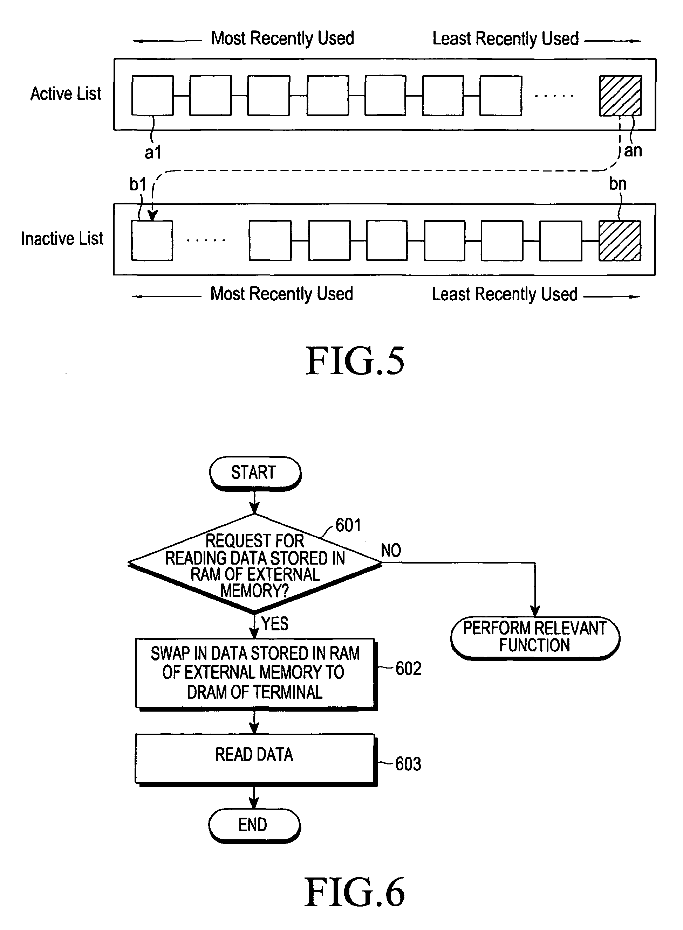

An example of an operation at operation the 306 for extending the RAM of the external memory to the system memory and causing the RAM of the external memory, which is extended to the system memory, to be used as the system memory, will be described in detail below with reference to FIGS. 4A to FIG. 6. FIG. 4A and FIG. 4B are flowcharts illustrating a process for swapping out data stored in a RAM of a terminal from the RAM of the terminal to a RAM of an external memory connected to the terminal, according to an embodiment of the present disclosure. FIG. 5 is a view illustrating a list enumerating data stored in a RAM of a terminal according to a frequency of use of the data, according to an embodiment of the present disclosure.

Referring to FIG. 5, an active list and an inactive list, as a list enumerating data stored in a RAM of a terminal according to the frequency of use of the data, are illustrated.

Hereinafter, an embodiment of the present disclosure will be described with reference to FIGS. 4A and 4B and FIG. 5 as well as with reference to FIG. 1 and FIG. 2.

Referring to FIGS. 4A and FIG. 4B, at operation 401, the controller 110 determines a request is made for recording new data.

If the controller 110 determines that a request is made for recording new data at operation 401, then the controller 110 proceeds to operation 402 at which the controller 110 determines whether the available memory capacity of the DRAM 130 of the terminal is sufficient to record the new data. For example, when a request is made for recording new data in the DRAM 130), the controller 110 detects that the request is made for recording new data in the DRAM 130, and thereafter identifies the memory capacity of the DRAM.

If the controller 110 determines that the available memory capacity of the DRAM 130 is sufficient to record the new data at operation 402, then the controller 110 proceeds to operation 403 at which the controller 110 stores the new code or new data in the DRAM 130. For example, when available space capable of recording the new data exists in the DRAM 130, the controller 110 detects that the available space capable of recording the new data exists in the DRAM 130, and proceeds to operation 403.

In contrast, if the controller 110 determines that the available memory capacity of the DRAM 130 is insufficient to record the new data at operation 402, then the controller 110 proceeds to operation 404 at which the controller 110 identifies the frequency of use of code or data recorded as having a lowest priority in an active list. For example, when the available space capable of recording the new data is insufficient in the DRAM 130, the controller 110 detects that the available space capable of recording the new data is insufficient in the DRAM 130, and proceeds to operation 404. As an example, at operation 404, the controller 110 first compares the frequency of use of data or a code aₙ, which is recorded as having the lowest priority in an active list, with a first reference value.

If the controller 110 determines that the frequency of use of the data or the code aₙ recorded as having a lowest priority in the active list is less than the first reference value at operation 405, then the controller 110 proceeds to operation B of FIG. 4B. For example, when the frequency of use of the data or code aₙ which is recorded as having the lowest priority in the active list is greater than the first reference value at operation 405, the controller 110 detects that the frequency of use of the data or code aₙ which is recorded as having the lowest priority in the active list is greater than the first reference value, and proceeds to operation B of FIG. 4B corresponding to operation 409.

At operation 409, the controller 110 records the data or code aₙ, which is recorded as having the lowest priority in the active list, as data or code aₗ having the highest priority in the active list. Thereafter, the controller 110 proceeds to operation C of FIG. 4A corresponding to operation 404.

In contrast, if the controller 110 determines that the frequency of use of the data or the code an recorded as having a lowest priority in the active list is greater than or equal to the first reference value at operation 405, then the controller 110 proceeds to operation 406 at which the controller 110 records the data or the code bₗ as data having a highest priority in the inactive list. For example, when the frequency of use of the data or code aₙ which is recorded as having the lowest priority in the active list is greater than or equal to the first reference value, the controller 110 detects that the frequency of use of the data or code aₙ which is recorded as having the lowest priority in the active list is greater than or equal to the first reference value, and proceeds to operation 406. As an example, at operation 406, the controller 110 records the data or code aₙ, which is recorded as having the lowest priority in an active list, as data or code bₗ having the highest priority in an inactive list. Thereafter, the controller 110 proceeds to operation 407.

At operation 407, the controller 110 identifies a frequency of use of code or data recorded as having a lowest priority in an inactive list. Thereafter, the controller 110 proceeds to operation A of FIG. 4B corresponding to operation 408.

At operation 408, the controller 110 compares the frequency of use of data or a code bₙ, which is recorded as having the lowest priority in the inactive list, with a second reference value.

If the controller 110 determines that the frequency of use of the data or code bₙ which is recorded as having the lowest priority in the inactive list is greater than the second reference value at operation 408, then the controller 110 proceeds to operation 409 at which the controller 110 records the data or code as data or code aₗ having the highest priority in the active list. For example, when the frequency of use of the data or code bₙ which is recorded as having the lowest priority in the inactive list is greater than the second reference value, the controller 110 detects that the frequency of use of the data or code bₙ which is recorded as having the lowest priority in the inactive list is greater than the second reference value, and proceeds to operation 409. For example, at operation 409, the controller 110 records the data or code bₙ, which is recorded as data or code aₗ having the lowest priority in the inactive list, as the data aₗ having the highest priority in the active list.

In contrast, if the controller 110 determines that the frequency of use of the data or code bₙ which is recorded as having the lowest priority in the inactive list is less than or equal the second reference value at operation 408, then the controller 110 proceeds to operation 410 at which the controller 110 determines whether the data or code bₙ recorded as having the lowest priority in the inactive list corresponds to code. For example, when the frequency of use of the data or code bₙ which is recorded as having the lowest priority in the inactive list is less than or equal to the second reference value, the controller 110 detects that the frequency of use of the data or code bₙ which is recorded as having the lowest priority in the inactive list is less than or equal to the second reference value at operation 408, and deletes or swaps out the data or code bₙ recorded as having the lowest priority in the inactive list.

If the controller 110 determines that the data or code bₙ recorded as having the lowest priority in the inactive list corresponds to code at operation 410, then the controller 110 proceeds to operation 411 at which the controller 110 deletes the code. For example, a code is recorded as having the lowest priority in the inactive list, the controller 110 detects that the code is recorded as having the lowest priority in the inactive list, and deletes the code at operation 411. Thereafter, the controller 110 proceeds to operation 412.

At operation 412, the controller 110 stores new data or a new code within available space of the DRAM secured by deleting the code. At this time, the controller 110 performs a control operation for recording the data, which has been newly stored in the DRAM 130, as data having the highest priority in the active list.

In contrast, if the controller 110 determines that the data or code bₙ recorded as having the lowest priority in the inactive list does not correspond to code at operation 410, then the controller 110 proceeds to operation 413 at which the controller 110 determines whether the data or code bₙ recorded as having the lowest priority in the inactive list corresponds to data.

If the controller 110 determines that the data or code bₙ recorded as having the lowest priority in the inactive list does not correspond to data at operation 413, then the controller 110 proceeds to operation 410.

In contrast, if the controller 110 determines that the data or code bₙ recorded as having the lowest priority in the inactive list corresponds to data at operation 413, then the controller 110 proceeds to operation 414 at which the controller 110 swaps out the data to RAM of the external memory. For example, when data is recorded as having the lowest priority in the inactive list, the controller 110 detects that the data is recorded as having the lowest priority in the inactive list, and proceeds to operation 414. At operation 414, the controller 110 swaps out the data from the DRAM 130 of the terminal to the RAM of the external memory 200 in a unit of page. Thereafter, the controller 110 proceeds to operation 412 at which the controller 110 stores new data or a new code within available space of the DRAM which is secured by swapping out the data.

After the controller 110 swaps out the data stored in the DRAM 130 from the DRAM 130 to the RAM of the external memory 200, the controller 110 changes a storage position information of the data to a predetermined address value of the RAM of the external memory and records the predetermined address value of the RAM of the external memory as the changed storage position information of the data, in a page management table.

In contrast, if the controller 110 determines that a request is not made for recording new data at operation 401, then the controller 110 proceeds to operation 415 at which the controller 110 determines whether a request is made for recording new code.

If the controller 110 determines that a request is not made for recording new code at operation 415, then the controller 110 proceeds to perform a corresponding function of the terminal.

In contrast, if the controller 110 determines that a request is made for recording new code at operation 415, then the controller 110 proceeds to operation 416 at which the controller 110 determines whether the available memory capacity of the DRAM 130 of the terminal is sufficient to record the new code. For example, when a request is made for recording a new code in the DRAM 130, the controller 110 detects that the request is made for recording a new code in the DRAM 130, and identifies the memory capacity of the DRAM.

If the controller 110 determines that the available memory capacity of the DRAM 130 of the terminal is sufficient to record the new code at operation 416, then the controller 110 proceeds to operation 403 at which the controller stores the code in the DRAM 130 of the terminal. For example, when available space capable of recording the new code exists in the DRAM 130, the controller 110 detects that the available space capable of recording the new code exists in the DRAM 130, and proceeds to operation 403. As an example, at operation 403, the controller 110 records the new code in the DRAM 130.

In contrast, if the controller 110 determines that the available memory capacity of the DRAM 130 of the terminal is insufficient to record the new code at operation 416, then the controller 110 proceeds to operation 407 at which the controller 110 identifies a frequency of use of code or data recorded as having a lowest priority in the inactive list. For example, when the available space capable of recording the new code is insufficient in the DRAM 130, the controller 110 detects that the available space capable of recording the new code is insufficient in the DRAM 130, and proceeds to operation 407. At operation 408, the controller 110 compares the frequency of use of data or a code, which is recorded as having the lowest priority in the inactive list, with the second reference value. Then, the controller 110 proceeds to and performs operations 409 to 414.

According to the related art, only when a code is recorded as having the lowest priority in the inactive list, the code is deleted. When data is recorded as having the lowest priority in the inactive list, the data is recorded as having the highest priority in the active list. Accordingly, when codes are all deleted and only data is stored in the DRAM, available space capable of recording new data or codes is not secured any longer.

However, according to various embodiments of the present disclosure, it is possible to secure available space capable of recording new data or codes in the DRAM 130 of the terminal, in such a manner as to delete a code, which is recorded as having the lowest priority in the inactive list, and swap out data, which is recorded as having the lowest priority in the inactive list, from the DRAM 130 of the terminal to the RAM of the external memory, as described above with reference to FIG. 4A and FIG. 4B. In addition, the RAM of the external memory is not physically connected to a Direct Memory Access (DMA) controller, but is connected to the high-speed storage control unit 112, and thereby can be used as an extended virtual system memory.

FIG. 6 is a flowchart illustrating a process for swapping in data stored in a RAM of an external memory connected to a terminal from the RAM of the external memory to a RAM in the terminal, according to an embodiment of the present disclosure. Hereinafter, an embodiment of the present disclosure will be described with reference to FIG. 6 as well as with reference to FIG. 1.

Referring to FIG. 6, at operation 601, the controller 110 determines whether a request is made for reading data stored in RAM of external memory 200.

If the controller 110 determines that a request is not made for reading data stored in the RAM of the external memory 200 at operation 601, then the controller 110 proceeds to perform a corresponding function of the terminal.

In contrast, if the controller 110 determines that a request is made for reading stored in the RAM of the external memory 200 at operation 601, then the controller 110 proceeds to operation 602 at which the controller 110 swaps in data stored in the RAM of the external memory 200 to the DRAM 130 of the terminal. For example, when data is requested, if a page management table indicates that a storage position information of the requested data corresponds to the RAM of the external memory 200 which is inserted into the socket unit 120, the controller 110 detects that the request is made for reading the data stored in the RAM of the external memory 200, and proceeds to operation 602. For example, at operation 602, the controller 110 swaps in the data stored in the RAM of the external memory 200 from the RAM of the external memory 200 to an empty area of the DRAM 130 of the terminal.

After the controller 110 swaps in the data at operation 602, the controller 110 changes a storage position information of the data to an address value of the empty area in the DRAM 130, in which the data is stored, and records the address value of the empty area as the changed storage position information of the data, in the page management table.

In addition, the controller 110 records the data, which has been swapped in from the RAM of the external memory 200 to the DRAM 130, as data having the highest frequency of use in the active list.

At operation 603, the controller 110 reads the data which has been swapped in from the RAM of the external memory 200 to the DRAM 130.

The apparatus and the method for extending a memory in the terminal, according to an embodiment of the present disclosure, may be implemented as computer-readable codes in a non-transitory computer-readable recording medium. The non-transitory computer-readable recording mediums include all types of recording devices which may be read by a computer system and on which data are stored. Examples of the recording medium include a Read Only Memory (ROM), a RAM, an optical disc, a magnetic tape, a floppy disk, a hard disc, a non-volatile memory, and the like. In addition, the non-transitory computer-readable recording mediums are distributed in a computer system connected to a network, so that computer-readable codes may be stored in the distributed storage mediums and be executed in a distributed scheme.

The apparatus and the method for extending a memory in the terminal, according to various embodiments of the present disclosure, can selectively extend a RAM of an external memory to a system memory, and thereby can use the RAM of the external memory, which is extended to the system memory. In addition, the speed of data movement is higher and the lifespan of the terminal is longer than in the case of an external memory having a built-in non-volatile memory.

While the present disclosure has been shown and described with reference to various embodiments thereof, it will be understood by those skilled in the art that various changes in form and details may be made therein without departing from the scope of the present disclosure as defined by the appended claims and their equivalents.

## Claims

1. A terminal comprising:
a socket unit into which an external memory having a built-in Random Access Memory (RAM) is inserted; and **characterized in that** the terminal is further comprising
a controller that performs a control operation for moving data stored in a RAM of the terminal to the RAM of the external memory and for securing available space of the RAM of the terminal, when the external memory having the built-in RAM is inserted into the socket unit.

2. The terminal of claim 1, wherein the controller includes a Universal Flash Storage (UFS) interface configured to move data between the RAM of the external memory and the RAM of the terminal at a high speed when the external memory having the built-in RAM is inserted into the socket unit.

3. The terminal of claim 1, wherein the controller performs a control operation for swapping in/out data in a unit of page between the RAM of the terminal and the RAM of the external memory by using a swap.

4. The terminal of claim 1, wherein the controller performs a control operation for receiving particular information from the external memory inserted into the socket unit, when a system booting operation is performed in the terminal, and
wherein the controller performs a control operation for registering the RAM of the external memory as a block device and for swapping in/out data between the RAM of the terminal and the RAM of the external memory by using a swap, when the controller determines, based on the received particular information, that the external memory has the built-in RAM.

5. The terminal of claim 1, wherein, when available space is insufficient in the RAM of the terminal when a request is made for recording new data or a new code, the controller performs a control operation for swapping out data, which has a lowest frequency of use among data stored in the RAM of the terminal, from the RAM of the terminal to the RAM of the external memory, and performs a control operation for recording the new data or code within the available space of the RAM of the terminal which is secured by swapping out the data having the lowest frequency of use to the RAM of the external memory,
wherein the controller performs a control operation for recording the data or code newly stored in the RAM of the terminal as data or code having a highest frequency of use.

6. The terminal of claim 5, wherein, after the controller performs the control operation for swapping out the data stored in the RAM of the terminal to the RAM of the external memory, the controller performs a control operation for changing a storage position information of the data swapped out to the RAM of the external memory, and performs a control operation for recording the changed storage position information thereof in a page management table.

7. The terminal of claim 1, wherein, when a request is made for reading data stored in the RAM of the external memory, the controller performs a control operation for swapping in the data stored in the RAM of the external memory from the RAM of the external memory to the RAM of the terminal and, performs a control operation for reading the data swapped in to the RAM of the terminal,
wherein the controller performs a control operation for recording the data, which has been swapped in from the RAM of the external memory to the RAM of the terminal, as data having a highest frequency of use.

8. The terminal of claim 7, wherein, after performing the control operation for swapping in the data stored in the RAM of the external memory from the RAM of the external memory to the RAM of the terminal, the controller performs a control operation for changing a storage position information of the data swapped in to the RAM of the terminal and recording the changed storage position information thereof in a page management table.

9. A method of extending a memory in a terminal, wherein a controller performs the method comprising:
determining a type of an external memory inserted into a socket unit of the terminal; and
securing available space of a Random Access Memory (RAM) of the terminal by moving data stored in the RAM of the terminal to a RAM of the external memory, when the external memory inserted into the socket unit of the terminal corresponds to an external memory having a built-in RAM.

10. The method of claim 9, wherein data is moved at a high speed between the RAM of the external memory and the RAM of the terminal through a Universal Flash Storage (UFS) interface, when the external memory having the built-in RAM is inserted into the socket unit.

11. The method of claim 9, wherein data is swapped in/out in a unit of page between the RAM of the terminal and the RAM of the external memory by using a swap.

12. The method of claim 9, wherein the determining of the type of the external memory comprises:
receiving particular information from the external memory through terminals configured to recognize the external memory having the built-in RAM which is included in the socket unit, when a system booting operation is performed in the terminal; and
determining whether the external memory inserted into the socket unit corresponds to the external memory having the built-in RAM, based on the particular information received from the external memory.

13. The method of claim 9, wherein the securing of the available space comprises registering the RAM of the external memory as a block device and swapping in/out data between the RAM of the terminal and the RAM of the external memory by using a swap, when the external memory is determined to have the built-in RAM.

14. The method of claim 9, wherein the securing of the available space comprises:
when available space is insufficient in the RAM of the terminal when a request is made for recording new data or a new code, swapping out data, which has a lowest frequency of use among data stored in the RAM of the terminal, from the RAM of the terminal to the RAM of the external memory;
recording the new data or code within the available space of the RAM of the terminal which is secured by swapping out the data having the lowest frequency of use to the RAM of the external memory; and
recording the data or code newly stored in the RAM of the terminal as data or code having a highest frequency of use.

15. The method of claim 14, further comprising:
after swapping out the data stored in the RAM of the terminal from the RAM of the terminal to the RAM of the external memory, changing a storage position information of the data swapped out to the RAM of the external memory, and recording the changed storage position information thereof in a page management table.

16. The method of claim 9, further comprising:
when a request is made for reading the data stored in the RAM of the external memory, swapping in data stored in the RAM of the external memory from the RAM of the external memory to the RAM of the terminal; reading the data swapped in to the RAM of the terminal; and
recording the data, which has been swapped in from the RAM of the external memory to the RAM of the terminal, as data having a highest frequency of use.

17. The method of claim 16, further comprising:
after swapping in the data stored in the RAM of the external memory from the RAM of the external memory to the RAM of the terminal, changing a storage position information of the data swapped in to the RAM of the terminal, and recording the changed storage position information thereof in a page management table.

## Patentansprüche

1. Endgerät, das Folgendes umfasst:
eine Buchseneinheit, in die ein externer Speicher mit einem eingebauten Random Access Memory (RAM - Direktzugriffsspeicher) eingesteckt ist; und **dadurch gekennzeichnet, dass** das Endgerät ferner Folgendes umfasst:
eine Steuereinheit, die einen Steuervorgang für Folgendes durchführt: Übertragen von Daten, die in einem RAM des Endgeräts gespeichert sind, zu dem RAM des externen Speichers und Sichern des verfügbaren Speicherplatzes des RAM des Endgeräts, wenn der externe Speicher mit dem eingebauten RAM in die Buchseneinheit eingesteckt ist.

2. Endgerät nach Anspruch 1, wobei die Steuereinheit eine Universal Flash Storage-Schnittstelle (UFS - universeller Flash-Speicher) umfasst, die dafür konfiguriert ist, Daten zwischen dem RAM des externen Speichers und dem RAM des Endgeräts mit hoher Geschwindigkeit zu übertragen, wenn der externe Speicher mit dem eingebauten RAM in die Buchseneinheit eingesteckt ist.

3. Endgerät nach Anspruch 1, wobei die Steuereinheit einen Steuervorgang zum Einlagern (Swap in) und Auslagern (Swap out) von Daten in einer Seiteneinheit zwischen dem RAM des Endgeräts und dem RAM des externen Speichers unter Verwendung einer Umlagerung (Swap) durchführt.

4. Endgerät nach Anspruch 1, wobei die Steuereinheit einen Steuervorgang zum Empfangen von bestimmten Informationen aus dem externen Speicher durchführt, der in die Buchseneinheit eingesteckt ist, wenn ein Systemhochladevorgang in dem Endgerät durchgeführt wird, und
wobei die Steuereinheit einen Steuervorgang für Folgendes durchführt: Registrieren des RAM des externen Speichers als Blockvorrichtung und Ein- und Auslagern von Daten zwischen dem RAM des Endgeräts und dem RAM des externen Speichers mit Hilfe einer Umlagerung, wenn die Steuereinheit basierend auf den bestimmten empfangenen Informationen bestimmt, dass der externe Speicher über den eingebauten RAM verfügt.

5. Endgerät nach Anspruch 1, wobei, wenn der verfügbare Speicherplatz in dem RAM des Endgeräts nicht ausreicht, wenn eine Anforderung zum Aufzeichnen neuer Daten oder eines neuen Codes vorgenommen wird, die Steuereinheit einen Steuervorgang zum Auslagern von Daten, die die niedrigste Nutzungshäufigkeit der Daten aufweisen, die in dem RAM des Endgeräts gespeichert sind, von dem RAM des Endgeräts in den RAM des externen Speichers durchführt und einen Steuervorgang zur Aufzeichnung der neuen Daten oder des neuen Codes in dem verfügbaren Speicherplatz des RAM des Endgeräts durchführt, der durch das Auslagern der Daten mit der niedrigsten Nutzungshäufigkeit in den RAM des externen Speichers gesichert ist,
wobei die Steuereinheit einen Steuervorgang zur Aufzeichnung der Daten oder des Codes, die neu im RAM des Endgeräts gespeichert wurden, als Daten oder Code mit einer höchsten Nutzungshäufigkeit durchführt.

6. Endgerät nach Anspruch 5, wobei, nachdem die Steuereinheit den Steuervorgang zum Auslagern der Daten, die in dem RAM des Endgeräts gespeichert sind, in den RAM des externen Speichers durchführt, die Steuereinheit einen Steuervorgang zum Ändern einer Speicherpositionsinformation der Daten durchführt, die in den RAM des externen Speichers ausgelagert werden, und einen Steuervorgang zur Aufzeichnung der geänderten Speicherpositionsinformation derselben in einer Seitenverwaltungstabelle durchführt.

7. Endgerät nach Anspruch 1, wobei, wenn eine Anfrage zum Lesen von Daten vorgenommen wird, die in dem RAM des externen Speichers gespeichert sind, die Steuereinheit einen Steuervorgang zum Einlagern der Daten, die in dem RAM des externen Speichers gespeichert sind, von dem RAM des externen Speichers in den RAM des Endgeräts durchführt, und einen Steuervorgang zum Lesen der Daten durchführt, die in den RAM des Endgeräts umgelagert wurden,
wobei die Steuereinheit einen Steuervorgang zur Aufzeichnung der Daten, die aus dem RAM des externen Speichers in den RAM des Endgeräts eingelagert wurden, als Daten mit der höchsten Nutzungshäufigkeit durchführt.

8. Endgerät nach Anspruch 7, wobei nach dem Durchführen des Steuervorgangs zum Einlagern der Daten, die in dem RAM des externen Speichers gespeichert sind, von dem RAM des externen Speichers in den RAM des Endgeräts die Steuereinheit einen Steuervorgang zur Änderung einer Speicherpositionsinformation der Daten, die in den RAM des Endgeräts eingelagert wurden, und zur Aufzeichnung der geänderten Speicherpositionsinformation derselben in einer Seitenverwaltungstabelle durchführt.

9. Verfahren zum Erweitern eines Speichers in einem Endgerät, wobei eine Steuereinheit das Verfahren durchführt, das Folgendes umfasst:
Bestimmen eines Typs eines externen Speichers, der in eine Buchseneinheit des Endgeräts eingesteckt ist, und
Sichern von verfügbarem Speicherplatz eines Random Access Memory (RAM) des Endgeräts durch Übertragen von Daten, die in dem RAM des Endgeräts gespeichert sind, in einen RAM des externen Speichers, wenn der externe Speicher, der in die Buchseneinheit des Endgeräts eingesteckt ist, einem externen Speicher mit eingebautem RAM entspricht.

10. Verfahren nach Anspruch 9, wobei Daten mit hoher Geschwindigkeit zwischen dem RAM des externen Speichers und dem RAM des Endgeräts durch eine Universal Flash Storage (UFS) -Schnittstelle übertragen werden, wenn der externe Speicher mit dem eingebauten RAM in die Buchseneinheit eingesteckt ist.

11. Verfahren nach Anspruch 9, wobei Daten in einer Seiteneinheit zwischen dem RAM des Endgeräts und dem RAM des externen Speichers unter Verwendung einer Umlagerung ein- und ausgelagert werden.

12. Verfahren nach Anspruch 9, wobei das Bestimmen des Typs des externen Speichers Folgendes umfasst:
Empfangen bestimmter Informationen von dem externen Speicher durch Endgeräte, die dafür konfiguriert sind, den externen Speicher mit dem eingebauten RAM zu erkennen, der in der Buchseneinheit enthalten ist, wenn ein Systemhochladevorgang in dem Endgerät durchgeführt wird; und
Bestimmen, ob der externe Speicher, der in die Buchseneinheit eingesteckt ist, dem externen Speicher mit dem eingebauten RAM basierend auf den bestimmten Informationen, die von dem externen Speicher empfangen werden, entspricht.

13. Verfahren nach Anspruch 9, wobei das Sichern des verfügbaren Speicherplatzes Folgendes umfasst: Registrieren des RAM des externen Speichers als Blockvorrichtung und Ein- und Auslagern von Daten zwischen dem RAM des Endgeräts und dem RAM des externen Speichers mit Hilfe einer Umlagerung, wenn bestimmt wird, dass der externe Speicher über den eingebauten RAM verfügt.

14. Verfahren nach Anspruch 9, wobei das Sichern des verfügbaren Speicherplatzes Folgendes umfasst:
wenn der verfügbare Speicherplatz in dem RAM des Endgeräts nicht ausreicht, wenn eine Anforderung zum Aufzeichnen neuer Daten oder eines neuen Codes vorgenommen wird, Auslagern von Daten, die die niedrigste Nutzungshäufigkeit der Daten aufweisen, die in dem RAM des Endgeräts gespeichert sind, von dem RAM des Endgeräts in den RAM des externen Speichers;
Aufzeichnen der neuen Daten oder des neuen Codes in dem verfügbaren Speicherplatz des RAM des Endgeräts, der durch das Auslagern der Daten mit der niedrigsten Nutzungshäufigkeit in den RAM des externen Speichers gesichert ist; und
Aufzeichnen der Daten oder des Codes, die neu im RAM des Endgeräts gespeichert wurden, als Daten oder Code mit einer höchsten Nutzungshäufigkeit.

15. Verfahren nach Anspruch 14, das ferner Folgendes umfasst:
nach dem Auslagern der Daten, die in dem RAM des Endgeräts gespeichert sind, von dem RAM des Endgeräts in den RAM des externen Speichers Ändern einer Speicherpositionsinformation der Daten, die in den RAM des externen Speichers ausgelagert werden, und Aufzeichnen der geänderten Speicherpositionsinformation derselben in einer Seitenverwaltungstabelle.

16. Verfahren nach Anspruch 9, das ferner Folgendes umfasst:
wenn eine Anfrage zum Lesen der Daten vorgenommen wird, die in dem RAM des externen Speichers gespeichert sind,
Einlagern von Daten, die in dem RAM des externen Speichers gespeichert sind, von dem RAM des externen Speichers in den RAM des Endgeräts; Lesen der Daten, die in den RAM des Endgeräts eingelagert werden; und
Aufzeichnen der Daten, die aus dem RAM des externen Speichers in den RAM des Endgeräts eingelagert wurden, als Daten mit der höchsten Nutzungshäufigkeit.

17. Verfahren nach Anspruch 16, das ferner Folgendes umfasst:
nach dem Einlagern der Daten, die in dem RAM des externen Speichers gespeichert sind, von dem RAM des externen Speichers in den RAM des Endgeräts, Ändern einer Speicherpositionsinformation der Daten, die in den RAM des Endgerätes eingelagert werden, und Aufzeichnen der geänderten Speicherpositionsinformation derselben in einer Seitenverwaltungstabelle.

## Revendications

1. Un terminal comprenant :
une unité de connexion dans laquelle une mémoire externe possédant une mémoire vive (RAM) intégrée est insérée, et **caractérisé en ce que** le terminal comprend en outre
un dispositif de commande qui exécute une opération de commande destinée à un déplacement de données conservées en mémoire dans une RAM du terminal vers la RAM de la mémoire externe et à la réservation d'un espace disponible de la RAM du terminal lorsque la mémoire externe possédant la RAM intégrée est insérée dans l'unité de connexion.

2. Le terminal selon la Revendication 1, où le dispositif de commande comprend une interface de stockage flash universel (UFS) configurée de façon à déplacer des données entre la RAM de la mémoire externe et la RAM du terminal à haute vitesse lorsque la mémoire externe possédant la RAM intégrée est insérée dans l'unité de connexion.

3. Le terminal selon la Revendication 1, où le dispositif de commande exécute une opération de commande destinée à un permutation en entrée/sortie de données dans une unité de page entre la RAM du terminal et la RAM de la mémoire externe au moyen d'une permutation.

4. Le terminal selon la Revendication 1, où le dispositif de commande exécute une opération de commande destinée à la réception d'informations particulières à partir de la mémoire externe insérée dans l'unité de connexion lorsqu'une opération d'amorçage système est exécutée dans le terminal, et
où le dispositif de commande exécute une opération de commande destinée à l'enregistrement de la RAM de la mémoire externe sous la forme d'un dispositif bloc et à une permutation en entrée/sortie de données entre la RAM du terminal et la RAM de la mémoire externe au moyen d'une permutation lorsque le dispositif de commande détermine, en fonction des informations particulières reçues, que la mémoire externe possède la RAM intégrée.

5. Le terminal selon la Revendication 1, où, lorsque l'espace disponible est insuffisant dans la RAM du terminal lorsqu'une demande est effectuée en vue d'enregistrer de nouvelles données ou un nouveau code, le dispositif de commande exécute une opération de commande destinée à la permutation en sortie des données qui possèdent une fréquence d'utilisation la plus basse parmi les données conservées en mémoire dans la RAM du terminal, de la RAM du terminal vers la RAM de la mémoire externe, et exécute une opération de commande en vue d'enregistrer les nouvelles données ou le nouveau code à l'intérieur de l'espace disponible de la RAM du terminal qui est réservé par la permutation en sortie des données possédant la fréquence d'utilisation la plus basse vers la RAM de la mémoire externe,
où le dispositif de commande exécute une opération de commande en vue d'enregistrer les données ou le code nouvellement conservés en mémoire dans la RAM du terminal sous la forme de données ou de code possédant une fréquence d'utilisation la plus élevée.

6. Le terminal selon la Revendication 5, où, une fois que le dispositif de commande a exécuté l'opération de commande destinée à la permutation en sortie des données conservées en mémoire dans la RAM du terminal vers la RAM de la mémoire externe, le dispositif de commande exécute une opération de commande destinée à modifier des informations de position de conservation en mémoire des données permutées en sortie vers la RAM de la mémoire externe et exécute une opération de commande en vue d'enregistrer les informations de position de conservation en mémoire modifiées de celle-ci dans une table de gestion de pages.

7. Le terminal selon la Revendication 1, où, lorsqu'une demande est effectuée destinée à la lecture de données conservées en mémoire dans la RAM de la mémoire externe, le dispositif de commande exécute une opération de commande destinée à la permutation en entrée des données conservées en mémoire dans la RAM de la mémoire externe de la RAM de la mémoire externe vers la RAM du terminal et exécute une opération de commande destinée à la lecture des données permutées en entrée vers la RAM du terminal,
où le dispositif de commande exécute une opération de commande en vue d'enregistrer les données qui ont été permutées en entrée de la RAM de la mémoire externe vers la RAM du terminal en tant que données possédant une fréquence d'utilisation la plus élevée.

8. Le terminal selon la Revendication 7, où, après l'exécution de l'opération de commande destinée à la permutation en entrée des données conservées en mémoire dans la RAM de la mémoire externe de la RAM de la mémoire externe vers la RAM du terminal, le dispositif de commande exécute une opération de commande destinée à modifier des informations de position de conservation en mémoire des données permutées en entrée vers la RAM du terminal et à enregistrer les informations de position de conservation en mémoire modifiées de celle-ci dans une table de gestion de pages.

9. Un procédé d'extension d'une mémoire dans un terminal, où un dispositif de commande exécute le procédé comprenant :
la détermination d'un type d'une mémoire externe insérée dans une unité de connexion du terminal, et
la réservation d'un espace disponible d'une mémoire vive (RAM) du terminal par le déplacement de données conservées en mémoire dans la RAM du terminal vers une RAM de la mémoire externe lorsque la mémoire externe insérée dans l'unité de connexion du terminal correspond à une mémoire externe possédant une RAM intégrée.

10. Le procédé selon la Revendication 9, où des données sont déplacées à haute vitesse entre la RAM de la mémoire externe et la RAM du terminal par l'intermédiaire d'une interface de stockage flash universel (UFS) lorsque la mémoire externe possédant la RAM intégrée est insérée dans l'unité de connexion.

11. Le procédé selon la Revendication 9, où des données sont permutées en entrée/sortie dans une unité de page entre la RAM du terminal et la RAM de la mémoire externe au moyen d'une permutation.

12. Le procédé selon la Revendication 9, où la détermination du type de la mémoire externe comprend :
la réception d'informations particulières à partir de la mémoire externe par l'intermédiaire de terminaux configurés de façon à identifier la mémoire externe possédant la RAM intégrée qui est incluse dans l'unité de connexion lorsqu'une opération d'amorçage système est exécutée dans le terminal, et
la détermination si la mémoire externe insérée dans l'unité de connexion correspond à la mémoire externe possédant la RAM intégrée en fonction des informations particulières reçues à partir de la mémoire externe.

13. Le procédé selon la Revendication 9, où la réservation de l'espace disponible comprend l'enregistrement de la RAM de la mémoire externe sous la forme d'un dispositif bloc et la permutation en entrée/sortie de données entre la RAM du terminal et la RAM de la mémoire externe au moyen d'une permutation lorsque la mémoire externe est déterminée posséder la RAM intégrée.

14. Le procédé selon la Revendication 9, où la réservation de l'espace disponible comprend :
lorsqu'un espace disponible est insuffisant dans la RAM du terminal lorsqu'une demande est effectuée en vue d'enregistrer de nouvelles données ou un nouveau code, la permutation en sortie de données qui possèdent une fréquence d'utilisation la plus basse parmi les données conservées en mémoire dans la RAM du terminal, de la RAM du terminal vers la RAM de la mémoire externe,
l'enregistrement des nouvelles données ou du nouveau code à l'intérieur de l'espace disponible de la RAM du terminal qui est réservé par la permutation en sortie des données possédant la fréquence d'utilisation la plus basse vers la RAM de la mémoire externe, et
l'enregistrement des données ou du code nouvellement conservés en mémoire dans la RAM du terminal sous la forme de données ou de code possédant une fréquence d'utilisation la plus élevée.

15. Le procédé selon la Revendication 14, comprenant en outre :
après la permutation en sortie des données conservées en mémoire dans la RAM du terminal de la RAM du terminal vers la RAM de la mémoire externe, la modification d'informations de position de conservation en mémoire des données permutées en sortie vers la RAM de la mémoire externe et l'enregistrement des informations de position de conservation en mémoire modifiées de celle-ci dans une table de gestion de pages.

16. Le procédé selon la Revendication 9, comprenant en outre :
lorsqu'une demande est effectuée en vue de la lecture des données conservées en mémoire dans la RAM de la mémoire externe, la permutation en entrée des données conservées en mémoire dans la RAM de la mémoire externe de la RAM de la mémoire externe vers la RAM du terminal, la lecture des données permutées en entrée vers la RAM du terminal, et
l'enregistrement des données qui ont été permutées en entrée de la RAM de la mémoire externe vers la RAM du terminal en tant que données possédant une fréquence d'utilisation la plus élevée.

17. Le procédé selon la Revendication 16, comprenant en outre :
après la permutation en entrée des données conservées en mémoire dans la RAM de la mémoire externe de la RAM de la mémoire externe vers la RAM du terminal, la modification d'informations de position de conservation en mémoire des données permutées en entrée vers la RAM du terminal et l'enregistrement des informations de position de conservation en mémoire modifiées de celle-ci dans une table de gestion de pages.
